# EUROPEAN PATENT APPLICATION

(11) **EP 4 753 380 A1**
(43) Date of publication of application: **03.06.2026**
(21) Application number: 25215379.6
(22) Date of filing: 12.11.2025
(51) Int. Cl.: H05K 1/02, H05K 3/30, H05K 1/11

(54) **PRINTED CIRCUIT BOARD, SYSTEM, AND IMAGE FORMING APPARATUS**

(30) Priority: 02.12.2024 JP 2024209698
(71) Applicant: Canon Kabushiki Kaisha, Tokyo, 146-8501 (JP)
(72) Inventor: HARAGUCHI, Takahiro, Tokyo, 146-8501 (JP)
(74) Representative: Canon Europe Limited

(57) **Abstract**

In a case where an electrode-equipped button battery and a button battery socket are mutually exclusively mounted on a printed circuit board, a pattern prohibition region of one component is not overlapped with a mounting pattern of the other component, and outer shape regions of the two components are at least partially overlapped with each other on the printed circuit board.

## Description

### Technical Field

The present disclosure relates to a printed circuit board and an image forming apparatus.

### BACKGROUND

Conventionally, a technique has been proposed concerning component mounting lands for electronic components on a printed circuit board that allows mutually exclusive mounting of different electronic components at the same location, even when the components are electrically compatible but have different layouts of component mounting lands for solder joints where electronic components are mounted on the printed circuit board.

For example, Japanese Patent Laid-Open No. 2006-210735 describes a technique for arranging component mounting lands for an electronic component having a smaller inter-terminal pitch inside component mounting lands for an electronic component having a larger inter-terminal pitch, to minimize the area occupied on the board by electronic components that are mounted mutually exclusively.

A controller unit mounted on an image forming apparatus includes a clock unit. To keep accurate time even when the image forming apparatus is turned OFF, the clock unit is supplied with power from a button battery. Power supply by the button battery is implemented by mounting an electrode-equipped button battery, in which electrodes are attached to a button battery, on the printed circuit board, or by mounting a button battery socket on the printed circuit board and fitting a button battery into the button battery socket.

To enable switching between a case where power is supplied to the clock unit from an electrode-equipped button battery mounted on the printed circuit board and a case where power is supplied to the clock unit from a button battery fitted to a button battery socket on the same printed circuit board, it is necessary to devise the arrangement of the component mounting lands.

When providing component mounting lands for an electrode-equipped button battery and a button battery socket on a printed circuit board, it is necessary to provide a pattern prohibited region beneath these components. A pattern prohibited area refers to a region where formation of a component mounting land, a signal wiring pattern, a signal wiring pattern VIA, a power supply pattern, a ground (GND) pattern, and a VIA are prohibited.

Against this background, there is a need for improved printed circuit boards.

### SUMMARY

The present disclosure in its first aspect provides a printed circuit board as specified in claim 1. By providing the printed circuit as set out above, a button battery and a button battery socket may be mutually exclusively mounted on the printed circuit board. By arranging the component mounting lands according to claim 1, the area occupied by the component (e.g. the first button battery, or the socket) is minimized on the printed circuit board, and the component is positioned outside the pattern prohibition region.

In some examples, the first button battery and the socket are each capable of being mounted on the printed circuit, but not concurrently (e.g. the capability of the first button battery being mounted on the printed circuit and the capability of the socket being mounted on the printed circuit are mutually exclusive). In some examples, the first electrode of the first button battery may not be mounted to the first mounting land in an event that the second electrode of the socket is mounted to the second mounting land and vice versa.

Optional features are specified in claims 2 to 16.

The present disclosure presents in its second aspect a system according to claim 17. The present disclosure in its third aspect provides an image forming apparatus as specified in claim 18. Optional features are specified in claims 1 and 16.

Features of the present disclosure will become apparent from the following description of embodiments with reference to the attached drawings. The following description of embodiments is described by way of example.

### BRIEF DESCRIPTION OF THE DRAWINGS

Fig. 1 is a block diagram illustrating a configuration of an image forming apparatus.
Fig. 2A is a top view illustrating a surface-mounted type electrode-equipped button battery. Fig. 2B is a side view illustrating the surface-mounted type electrode-equipped button battery. Fig. 2C is a top view illustrating a surface-mounted type button battery socket. Fig. 2D is a side view illustrating the surface-mounted type button battery socket.
Fig. 3 is a diagram illustrating an arrangement of component mounting lands of a surface-mounted type electrode-equipped button battery and a surface-mounted type button battery socket.
Fig. 4 is a diagram illustrating another arrangement of component mounting lands of the surface-mounted type electrode-equipped button battery and the surface-mounted type button battery socket.
Fig. 5 is a diagram illustrating an arrangement of openings of a Dual-In-Package (DIP) type electrode-equipped button battery and component mounting lands of a surface-mounted type button battery socket.
Fig. 6 is a diagram illustrating an arrangement of component mounting lands of a surface-mounted type electrode-equipped button battery and openings for mounting components of a DIP type button battery socket.
Fig. 7A is a diagram illustrating an arrangement of component mounting lands when a surface-mounted type electrode-equipped button battery is disposed on a front surface of a printed circuit board. Fig. 7B is a diagram illustrating an arrangement of component mounting lands when a surface-mounted type button battery socket is disposed on a back surface of the printed circuit board.
Fig. 8A is a diagram illustrating an arrangement of lands of an electrode-equipped button battery and lands of a connector on the printed circuit board of a controller unit. Fig. 8B is a diagram illustrating an arrangement of component mounting lands and a connector of a button battery socket on a sub-board for mounting the button battery socket.

### DESCRIPTION OF THE EMBODIMENTS

An embodiment in accordance with the present disclosure will be described below with reference to the accompanying drawings. The present disclosure will be described below with reference to the printed circuit board included in a controller unit 110 of an image forming apparatus 100. However, the present disclosure is not limited to the printed circuit board included in the controller unit 110.

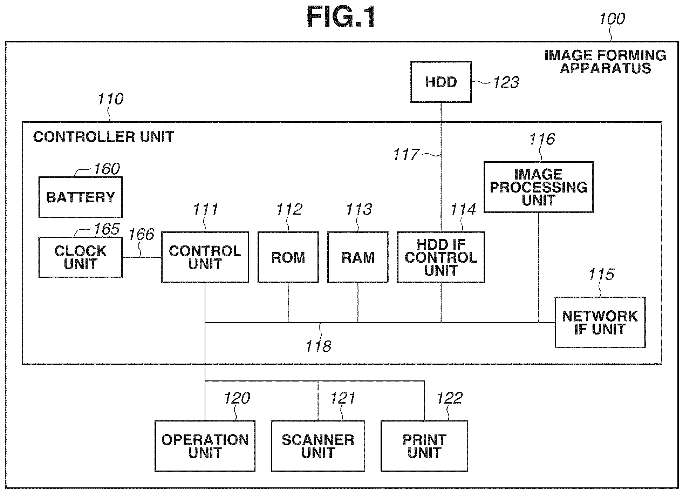

Fig. 1 is a block diagram illustrating a configuration of the image forming apparatus 100 on which the controller unit 110, to which the printed circuit board of the present disclosure is applied, is mounted.

The image forming apparatus 100 includes the controller unit 110, a hard disk drive (HDD) 123, an operation unit 120, a scanner unit 121, and a print unit 122. The controller unit 110 includes a control unit 111, a random access memory (RAM) 113, a read only memory (ROM) 112, an image processing unit 116, an HDD interface (IF) control unit 114, a network IF unit 115, a battery 160, and a clock unit 165, and controls entire operations of the image forming apparatus 100.

The control unit 111 controls the image forming apparatus 100 according to a program stored in the ROM 112. The control unit 111 further controls the clock unit 165. The network IF unit 115 is an interface for connecting the image forming apparatus 100 with a local area network (LAN). The network IF unit 115 is connected with the control unit 111 via a bus 118.

The RAM 113 is a working memory that is used by the control unit 111 to perform processing according to the ROM 112. The image processing unit 116 performs image processing on image data input from the scanner unit 121.

The HDD IF control unit 114 is a bridge circuit for converting the bus 118 into a bus 117. The RAM 113, the ROM 112, the image processing unit 116, and the HDD IF control unit 114 are connected with the control unit 111 via the bus 118. The HDD 123 is a nonvolatile storage device for storing data.

The storage device may be a storage device other than the HDD 123, such as a solid state drive (SSD).

The scanner unit 121 reads a document and inputs image data. The print unit 122 prints image data that has been input from the scanner unit 121 and subjected to image processing by the image processing unit 116 of the controller unit 110.

The operation unit 120 provides a user with various information via a display and inputs various instructions from the user via buttons and the like to the image forming apparatus 100. The operation unit 120, the scanner unit 121, and the print unit 122 are connected with the controller unit 110 via the bus 118. The HDD 123 is connected with the controller unit 110 via the bus 118.

The clock unit 165 has a clock function for managing the date and time. The clock unit 165 is connected with the control unit 111 via a bus 166. The battery 160 supplies power to the clock unit 165 to enable the clock unit 165 to accurately count the date and time even in a state where the image forming apparatus 100 is not supplied with power.

The battery 160 is an electrode-equipped button battery or a button battery attached to a button battery socket. The clock unit 165 provides a clock value to supply a time stamp to a file stored in the HDD 123 of the image forming apparatus 100.

Further, as an example of an application specific to the clock unit 165 of the image forming apparatus 100, the clock unit 165 may be used for control switching that changes initial control of the print unit 122 when the main power switch (not illustrated) of the image forming apparatus 100 is turned ON, based on an off-time duration of the image forming apparatus 100.

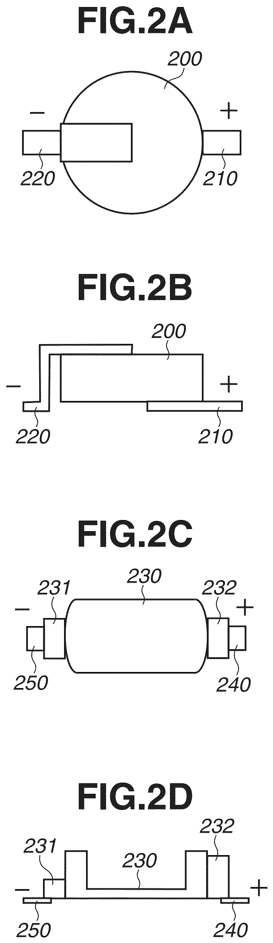

Fig. 2A is a top view illustrating the battery 160 according to the present disclosure as a surface-mounted type electrode-equipped button battery. Fig. 2B is a side view illustrating the surface-mounted type electrode-equipped button battery.

A button battery unit 200 (first button battery) is a main battery unit of the electrode-equipped button battery.

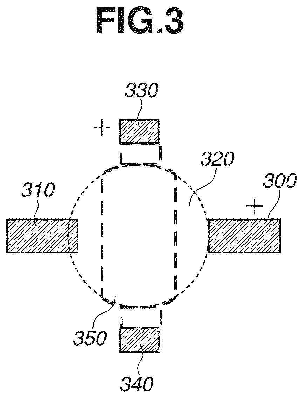

An electrode 210 is a positive electrode attached to the button battery unit 200. An electrode 220 is a negative electrode attached to the button battery unit 200. A pattern prohibition region of the electrode-equipped button battery indicated by a dotted-line circular portion 320 corresponds to a surface region beneath the button battery unit 200 (the dotted-line circular portion 320 may be seen in Fig. 3).

The pattern prohibition region indicated by the dotted-line circular portion 320 is a first pattern prohibition region. The electrode on a lower surface of the button battery unit 200 is the positive electrode having no insulating member. While the wiring pattern of the printed circuit board is covered with a resist, there is a possibility that the resist may be peeled off when the electrode-equipped button battery is placed on the printed circuit board.

In addition, there are cases that the VIA may not be covered by resist patterns. In such a case, if a wiring pattern or a VIA is present on the region beneath the button battery unit 200, the electrode on the lower surface of the button battery unit 200 may short-circuit (come into contact) with the wiring pattern or the VIA. Therefore, provision of a signal wiring pattern, a VIA of the signal wiring pattern, a GND pattern, and a VIA of the GND pattern in the pattern prohibition region of the electrode-equipped button battery indicated by the dotted-line circular portion 320 (restriction) is prohibited.

The outer shape region (first outer shape region) of the electrode-equipped button battery is an area occupied by the button battery unit 200, the electrode 210, and the electrode 220. This outer shape region is a region where the electrode-equipped button battery is mounted on the printed circuit board.

Fig. 2C is a top view illustrating a case where the battery 160 is a surface-mounted type button battery socket. Fig. 2D is a side view illustrating the surface-mounted type button battery socket.

A mold 230 is a portion for mounting a button battery (second button battery (not illustrated)). A mold 231 is a mold for fixing an electrode 250 of the button battery socket. A mold 232 is a mold for fixing an electrode 240 of the button battery socket.

The electrode 240 is an electrode of the button battery socket. When the button battery (not illustrated) is attached to the button battery socket, the electrode 240 serves as the positive electrode. The electrode 250 is an electrode of the button battery socket.

When a button battery (not illustrated) is attached to the button battery socket, the electrode 250 serves as the negative electrode. The pattern prohibition region of the button battery socket includes a portion of the mold 231 without the electrode 250, a portion of the mold 232 without the electrode 240, and a surface beneath the mold 230. The pattern prohibition region indicated by a broken-line portion 350 is referred to as a second pattern prohibition region.

The pattern prohibition region of the button battery socket is a region where the provision of component mounting lands that would extend into the surface beneath the button battery socket is inhibited (socket constraint).

Further, the pattern prohibition region of the button battery socket is a region where the provision of a VIA of a signal wiring pattern (pattern VIA) and a VIA of a GND pattern (pattern VIA) is prohibited (socket constraint). The pattern prohibition region of the button battery socket is a region where the provision of a signal wiring pattern and a GND pattern is not prohibited (socket constraint).

The outer shape region (second outer shape region) of the button battery socket is an area occupied by the molds 230, 231, and 232, and the electrodes 240 and 250. This outer shape region is a region where the button battery socket is mounted to the printed circuit board.

When a copper foil exposure portion is provided only on a back side of a surface on which the button battery socket is mounted, it is not prohibited to place a through-hole for a lead component (not illustrated), which is mounted simultaneously with the electrode-equipped button battery, within the pattern prohibition region of the button battery socket.

In addition, when a copper foil exposure portion is provided only on the back side of the surface on which the button battery socket is mounted, it is not prohibited to place a through-hole for attaching a spacer (not illustrated), which fixes a board, within the pattern prohibition region of the button battery socket.

In addition, when a copper foil exposure portion is provided only on the back side of the surface on which the electrode-equipped button battery is mounted, it is not prohibited to place a through-hole for a lead component (not illustrated), which is mounted simultaneously with the button battery socket, within the pattern prohibition region of the electrode-equipped button battery.

Further, when a copper foil exposure portion is provided only on the back side of the surface on which the electrode-equipped button battery is mounted, it is not prohibited to place a through-hole for attaching a spacer (not illustrated), which fixes a board, within the pattern prohibition region of the electrode-equipped button battery.

Fig. 3 is a diagram illustrating an arrangement of component mounting lands of a surface-mounted type electrode-equipped button battery and a surface-mounted type button battery socket.

Fig. 3 illustrates an example case in which the electrode-equipped button battery and the button battery socket are arranged orthogonally in such a manner that their outer shape regions are (at least partially) overlapped. A hatched portion 300 represents a component mounting land (first mounting land) on the side with the positive electrode of the surface-mounted type electrode-equipped button battery. A hatched portion 310 represents a component mounting land (first mounting land) on the side with the negative electrode of the surface-mounted type electrode-equipped button battery.

The dotted-line circular portion 320 indicates the pattern prohibition region of the surface-mounted type electrode-equipped button battery.

The dotted-line circular portion 320 also represents the outer shape region of the surface-mounted type electrode-equipped button battery. A hatched portion 330 represents the component mounting land (second mounting land) on the side with the positive electrode of the surface-mounted type button battery socket.

A hatched portion 340 represents the component mounting land (second mounting land) on the side with the negative electrode of the surface-mounted type button battery socket. The broken-line portion 350 indicates the outer shape region of the button battery socket.

In the case illustrated in Fig. 3, the component mounting lands (hatched portions 300 and 310) of the surface-mounted type electrode-equipped button battery and the component mounting lands (hatched portions 330 and 340) of the button battery socket are arranged orthogonally. The component mounting lands of the electrode-equipped button battery are larger than the electrodes 240 and 250 and the molds 231 and 232 of the button battery socket.

Accordingly, if the component mounting lands of the electrode-equipped button battery and the component mounting lands of the button battery socket are combined into a single common lands, the common land occupies a region extending beneath the molds 231 and 232 of the button battery socket.

In such a state, if the button battery socket is soldered, solder flows through the common land toward the land end on the mold 230 side. If solder flows through the common land toward the land end on the mold 230 side, the solder may cause the molds 231 and 232 to lift, which can result in mounting defects in the electrodes 240 and 250.

Therefore, in the present embodiment, the arrangement as illustrated in Fig. 3 is employed. However, in consideration of mounting, the component mounting lands (hatched portions 300 and 310) of the electrode-equipped button battery and the component mounting lands (hatched portions 330 and 340) of the button battery socket may be arranged in a non-orthogonal manner. In addition, if the button battery socket is smaller than the outer shape of the electrode-equipped button battery, the center position of the electrode-equipped button battery and the center position of the button battery socket may be offset from each other.

In such a case, the component mounting lands (hatched portions 330 and 340) of the button battery socket are arranged at positions where the component mounting lands (hatched portions 300 and 310) of the electrode-equipped button battery do not enter the outer shape region (broken-line portion 350) of the button battery socket.

With the arrangement illustrated in Fig. 3, when the component mounting lands of the electrode-equipped button battery and the component mounting lands of the button battery socket are provided on the printed circuit board, the area occupied by the two components on the printed circuit board can be reduced, which enables space saving.

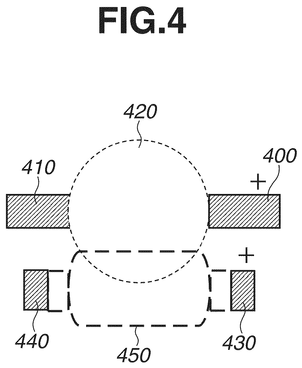

Fig. 4 is a diagram illustrating an arrangement of component mounting lands of the surface-mounted type electrode-equipped button battery and the surface-mounted type button battery socket.

Fig. 4 illustrates an example case in which the electrode-equipped button battery and the button battery socket are arranged side by side in such a manner that their outer shape regions are (at least partially) overlapped.

A hatched portion 400 represents a component mounting land on the side with the positive electrode of the surface-mounted type electrode-equipped button battery. A hatched portion 410 represents a component mounting land on the side with the negative electrode of the surface-mounted type electrode-equipped button battery. A dotted-line circular portion 420 indicates a pattern prohibition region of the surface-mounted type electrode-equipped button battery. The dotted-line circular portion 420 also represents the outer shape region of the surface-mounted type electrode-equipped button battery.

A hatched portion 430 represents a component mounting land on the side with the positive electrode of the surface-mounted type button battery socket. A hatched portion 440 is a component mounting land on the side with the negative electrode of the surface-mounted type button battery socket.

A broken-line portion 450 indicates an outer shape region of the button battery socket. With the arrangement illustrated in Fig. 4, when the component mounting lands of the electrode-equipped button battery and the component mounting lands of the button battery socket are provided on the printed circuit board, the area occupied by the two components on the printed circuit board can be reduced, which enables space saving.

There are also DIP type components available for an electrode-equipped button battery and a button battery socket. The following describes arrangement examples of component mounting lands for the electrode-equipped button battery and the button battery socket when a DIP type and a surface-mounted type are employed in combination.

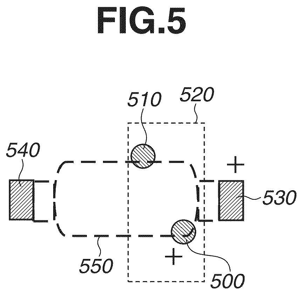

Fig. 5 is a diagram illustrating an arrangement of openings of a DIP type electrode-equipped button battery and component mounting lands of a surface-mounted type button battery socket.

A hatched circular portion 500 represents an opening for mounting a component on the side with the positive electrode of the DIP type electrode-equipped button battery.

A hatched circular portion 510 represents an opening for mounting a component on the side with the negative electrode of the DIP type electrode-equipped button battery. The hatched circular portions 500 and 510 are through-holes penetrating both the front and back surfaces of the printed circuit board, and component mounting lands are provided on the surface opposite to the component mounting surface.

A dotted-line rectangular portion 520 represents an outer shape region of the DIP type electrode-equipped button battery. A hatched portion 530 represents a component mounting land on the side with the positive electrode of the surface-mounted type button battery socket.

A hatched portion 540 represents a component mounting land on the side with the negative electrode of the surface-mounted type button battery socket.

A broken-line portion 550 represents an outer shape region of the button battery socket. With the arrangement illustrated in Fig. 5 (in which the components at least partially overlap), when the component mounting lands of the electrode-equipped button battery and the component mounting lands of the button battery socket are provided on the printed circuit board, the area occupied by the two components on the printed circuit board can be reduced, which enables space saving.

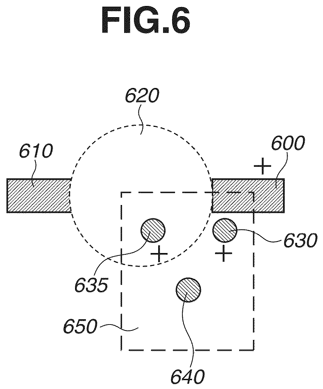

Fig. 6 is a diagram illustrating an arrangement of component mounting lands of a surface-mounted type electrode-equipped button battery and openings for mounting components of the DIP type button battery socket. A hatched portion 600 represents a component mounting land on the side with the positive electrode of the surface-mounted type electrode-equipped button battery.

A hatched portion 610 represents a component mounting land on the side with the negative electrode of the surface-mounted type electrode-equipped button battery. A dotted-line circular portion 620 indicates a pattern prohibition region of the surface-mounted type electrode-equipped button battery. The dotted-line circular portion 620 also represents an outer shape region of the surface-mounted type electrode-equipped button battery.

Hatched circular portions 630 and 635 represent openings for mounting components on the positive electrode side of the DIP type button battery socket. A hatched circular portion 640 represents an opening for mounting a component on the side with the negative electrode of the DIP type button battery socket.

The hatched circular portions 630, 635, and 640 are through-holes penetrating through both the front and back surfaces of the printed circuit board, and component mounting lands are formed on the surface opposite to the component mounting surface. A broken-line rectangular portion 650 indicates an outer shape region of the DIP type button battery socket.

With the arrangement illustrated in Fig. 6, when the component mounting lands of the electrode-equipped button battery and the component mounting lands of the button battery socket are provided on the printed circuit board, the area occupied by the two components on the printed circuit board can be reduced, which enables space saving.

There can also be a case in which the surface-mounted type electrode-equipped button battery and the button battery socket are disposed on the front and back surfaces of the printed circuit board, respectively. An example of an arrangement in such a case will be described below.

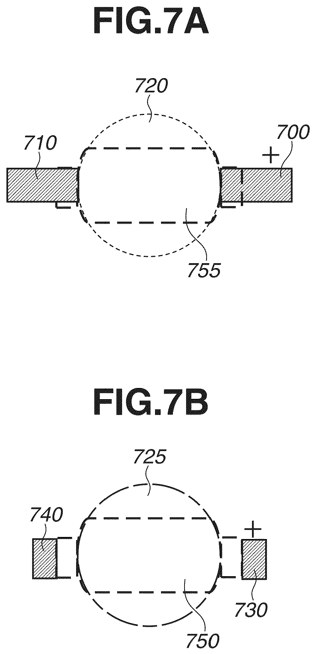

Fig. 7A is a diagram illustrating a case where a surface-mounted type electrode-equipped button battery is disposed on the front surface of the printed circuit board, and an outer shape region of a button battery socket on the back surface of the printed circuit board is indicated. Fig. 7B is a diagram illustrating a case where the surface-mounted type button battery socket is disposed on the back surface of the printed circuit board, and an outer shape region of the electrode-equipped button battery is indicated.

In the examples in Figs. 7A and 7B, the electrode-equipped button battery and the button battery socket are disposed on the front and back surfaces of the printed circuit board, respectively.

As illustrated in Fig. 7A, a pattern prohibition region indicated by a dotted-line circular portion 720 having the same shape as an outer shape region of the surface-mounted type electrode-equipped button battery (at least partly) overlaps with a shape 755 indicated as a projection of a broken-line portion 750 representing an outer shape region of the button battery socket disposed on the back surface.

As illustrated in Fig. 7B, the broken-line portion 750 representing the outer shape region of the button battery socket (at least partly) overlaps with a shape 725 indicated as a projection of the pattern prohibition region indicated by a dotted-line circular portion 720 of the electrode-equipped button battery disposed on the front surface.

A hatched portion 700 represents a component mounting land on the side with the positive electrode of the surface-mounted type electrode-equipped button battery. A hatched portion 710 represents a component mounting land on the side with the negative electrode of the surface-mounted type electrode-equipped button battery.

The dotted-line circular portion 720 indicates the pattern prohibition region of the surface-mounted type electrode-equipped button battery.

The dotted-line circular portion 720 also represents an outer shape region of the surface-mounted type electrode-equipped button battery. A hatched portion 730 is a component mounting land on the side with the positive electrode of the surface-mounted type button battery socket.

A hatched portion 740 is a component mounting land on the side with the negative electrode of the surface-mounted type button battery socket. The broken-line portion 750 indicates an outer shape region of the button battery socket.

There can also be a case in which the electrode-equipped button battery and the button battery socket are mounted on different printed circuit boards. An example of an arrangement in such a case will be described below.

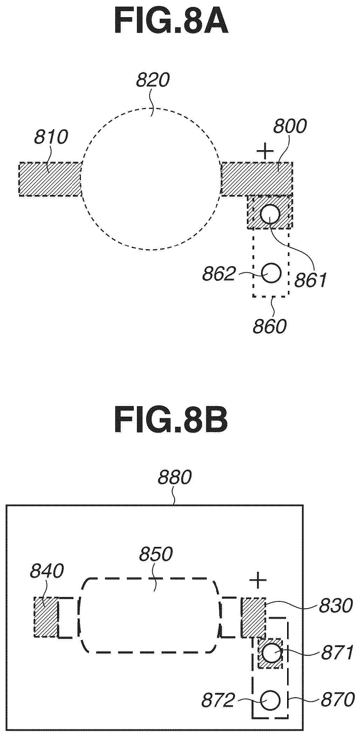

Figs. 8A and 8B are diagrams illustrating an electrode-equipped button battery and a button battery socket mounted on different printed circuit boards. Fig. 8A illustrates an arrangement of component mounting lands and a connector of the electrode-equipped button battery on the printed circuit board of the controller unit 110.

Fig. 8B illustrates an arrangement of component mounting lands and a connector of the button battery socket on a sub-board on which the button battery socket is mounted.

A hatched portion 800 is a component mounting land on the side with the positive electrode of the surface-mounted type electrode-equipped button battery. A hatched portion 810 is a component mounting land on the side with the negative electrode of the surface-mounted type electrode-equipped button battery.

A dotted-line circular portion 820 represents the pattern prohibition region of the surface-mounted type electrode-equipped button battery.

The dotted-line circular portion 820 also represents an outer shape region of the surface-mounted type electrode-equipped button battery.

A dotted-line rectangular portion 860 represents a connector. Circular portions 861 and 862 are through-holes for passing terminals of the connector (dotted-line rectangular portion 860). The through-hole indicated by the circular portion 861 is connected with the component mounting land indicated by the hatched portion 800 serving as a component mounting land on the side with the positive electrode of the electrode-equipped button battery. The through-hole indicated by the circular portion 862 is connected with a ground plane having the same potential as the component mounting land indicated by the hatched portion 810 serving as a component mounting land on the side with the negative electrode of the electrode-equipped button battery.

A substrate 880 on which the button battery socket is mounted represents the sub-board for supplying the battery 160 of the image forming apparatus 100 via a button battery socket board. A hatched portion 830 represents a component mounting land on the side with the positive electrode of the surface-mounted type button battery socket.

A hatched portion 840 represents a component mounting land on the side with the negative electrode of the surface-mounted type button battery socket. A broken-line portion 850 indicates an outer shape region of the button battery socket. A dotted-line rectangular portion 870 indicates a connector.

Circular portions 871 and 872 represent through-holes for passing terminals of the connector (dotted-line rectangular portion 870). The through-hole indicated by circular portion 871 is connected with the component mounting land indicated by the hatched portion 830 as a component mounting land on the side with the positive electrode of the button battery socket. The through-hole indicated by circular portion 872 is connected with a ground plane having the same potential as the component mounting land indicated by the hatched portion 840 as a component mounting land on the side with the negative electrode of the button battery socket.

When the electrode-equipped button battery is mounted on the printed circuit board of the controller unit 110, the connector (dotted-line rectangular portion 860) is not mounted on the printed circuit board of the controller unit 110.

When the connector (dotted-line rectangular portion 860) is mounted on the printed circuit board of the controller unit 110, the electrode-equipped button battery is not mounted on the printed circuit board of the controller unit 110.

In this case, by attaching the substrate 880 on which the button battery socket is mounted, to the controller unit 110, the clock unit 165 is supplied with power from the button battery mounted on the button battery socket via the connectors (dotted-line rectangular portions 860 and 870).

The first and the second button batteries may be of the same specification or different specifications.

More specifically, it is sufficient that the first button battery can be attached to the socket, and the electrodes of the button battery socket come into contact with the electrodes of the first button battery. Furthermore, the second button battery can be mounted on the printed circuit board in a similar manner to the first button battery, and it is sufficient that the electrodes, the pattern prohibition region, and the outer shape region of the second button battery are equivalent to the electrodes of the first button battery, the first pattern prohibition region, and the first outer shape region, respectively.

Further, as long as the circuit of the printed circuit board is applicable, it is possible to use different electrical specifications, such as different voltages of the first and the second button batteries.

Embodiments of the present disclosure have been described above. According to the above-described embodiments of the present disclosure, in a case where an electrode-equipped button battery and a button battery socket are mutually exclusively mounted on the printed circuit board, a mounting pattern of one component does not overlap with a pattern prohibition region of the other component, which enables a reduction in an area for mounting these components. However, the present disclosure is not limited to the above-described embodiments. More specifically, the present disclosure includes embodiments modified in diverse ways based on the scope of the present disclosure, and these embodiments are not excluded from the scope of the present disclosure.

### Other Embodiments

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

## Claims

1. A printed circuit board on which a first button battery (200) or a socket for a second button battery is capable of being mounted, the first button battery (200) including a first electrode (210, 220), and defining a first pattern prohibition region (320) and a first outer shape region (320), the socket including a second electrode (240, 250), and defining a second pattern prohibition region (350) and a second outer shape region (350), the printed circuit board comprising:
a first mounting land (300, 310) for mounting the first electrode (210, 220); and
a second mounting land (330, 340) for mounting the second electrode (240, 250);
wherein the first mounting land (300, 310) is disposed in a region of the printed circuit board different from the second pattern prohibition region (350), and the second mounting land (330, 340) is disposed in a region of the printed circuit board different from the first pattern prohibition region (320), and
wherein the first mounting land (300, 310) and the second mounting land (330, 340) are disposed on the printed circuit in such a manner that the first outer shape (320) region and the second outer shape region (350) are at least partially overlapped on the printed circuit board.

2. The printed circuit board according to claim 1, further comprising the first button battery, wherein the first button battery (200) is connected with the printed circuit via the first electrode (210, 220) of the first button battery (200) and a member (210, 220) for connecting the first electrode (210, 220) with patterns of the printed circuit board.

3. The printed circuit board according to any preceding claim, wherein the first outer shape region (320) is a region of the printed circuit board that is used for mounting the first button battery (200), and the second outer shape region (350) is a region of the printed circuit board that is used for mounting the socket.

4. The printed circuit board according to any preceding claim, wherein the second button battery can be attached to the socket.

5. The printed circuit board according to any preceding claim, wherein the first pattern prohibition region (320) is a region on the printed circuit board in which a pattern arrangement is prohibited, the region being provided based on a constraint related to component mounting for the first button battery (200).

6. The printed circuit board according to claim 5, wherein the constraint related to component mounting for the first button battery is a constraint for preventing the first electrode (201, 220) of the first button battery (200) from coming into contact with a pattern of the printed circuit board different from the first mounting land (300, 310).

7. The printed circuit board according to claim 6, wherein the pattern of the printed circuit board different from the first mounting land (300, 310) is a wiring pattern of the printed circuit board or a VIA of the wiring pattern.

8. The printed circuit board according to any preceding claim, wherein the second pattern prohibition region (350) is a region on the printed circuit board in which a pattern arrangement is prohibited, the region being provided based on a constraint related to component mounting for the socket.

9. The printed circuit board according to claim 8, wherein the constraint related to component mounting for the socket is a constraint for preventing the second mounting land from being arranged in a manner that the second mounting land extends beneath a bottom surface of the socket.

10. The printed circuit board according to claim 8, wherein the constraint related to component mounting for the socket is a constraint for preventing a pattern VIA of the printed circuit board from being arranged beneath a bottom surface of the socket.

11. The printed circuit board according to claim 10, wherein the pattern VIA of the printed circuit board is a wiring pattern and a ground, GND, pattern of the printed circuit board.

12. The printed circuit board according to claim 1, wherein the first button battery (200) is capable of being attached to the socket.

13. The printed circuit board according to claim 1, wherein an electrode of the second button battery, the second pattern prohibition region (350), and the second outer shape region (350) correspond to the first electrode (210, 220), the first pattern prohibition region (320), and the first outer shape region (320), respectively.

14. The printed circuit board according to claim 1, wherein the first button battery (200) and the second button battery are of a same specification.

15. The printed circuit board according to claim 2, wherein the first button battery (200) is mounted such that the first electrode (210, 220) is connected via the member (210, 220).

16. The printed circuit board according to claim 1, wherein the second button battery is mounted on the socket.

17. A system comprising a first printed circuit board on which a first button battery is capable of being mounted, and a second printed circuit board on which a socket for a second button battery is capable of being mounted, the first printed circuit board being connectable to the second printed circuit board, the first button battery including a first electrode, and defining a first pattern prohibition region (820) and a first outer shape region (820), the socket including a second electrode, and defining a second pattern prohibition region (850) and a second outer shape region (850), the first printed circuit board comprising:
a first mounting land (800, 810) for mounting the first electrode; and the second printed circuit board comprising:
a second mounting land (830, 840) for mounting the second electrode;
wherein, with the first printed circuit board connected to the second printed circuit board:
the first mounting land (800, 810) is disposed in a region of the first printed circuit board different from the second pattern prohibition region (850), and the second mounting land (830, 840) is disposed in a region of the second printed circuit board different from the first pattern prohibition region (820), and
the first mounting land (800, 810) and the second mounting land (830, 840) are disposed on the first and second printed circuit boards in such a manner that the first outer shape region (820) and the second outer shape region (850) are at least partially overlapped on the first and second printed circuit boards.

18. An image forming apparatus (100) comprising a printed circuit board according to any one of claims 1 to 16, or the system according to claim 17.
